# EUROPÄISCHE PATENTSCHRIFT

(11) **EP 0 898 369 B1**
(45) Veröffentlichungstag und Bekanntmachung des Hinweises auf die Patenterteilung: **29.12.2004**
(21) Anmeldenummer: 98115853.8
(22) Anmeldetag: 21.08.1998
(51) Int. Cl.: H03K 17/97

(54) **Kontaktloser Näherungsschalter**
Proximity switch
Commutateur de proximité

(30) Priorität: 21.08.1997 DE 19736454
(43) Veröffentlichungstag der Anmeldung: 24.02.1999
(73) Patentinhaber: Infineon Technologies AG, 81669 München (DE)
(72) Erfinder: Hufgard, Erich, Dipl.-Phys., 93049 Regensburg (DE); Wecker, Joachim, Dr. Dipl.-Phys., 91341 Röttenbach (DE); Steinkirchner, Jürgen, Dipl.-Ing. (FH), 93413 Cham (DE); Clemens, Wolfgang, Dr. Dipl.-Phys., 90617 Puschendorf (DE)
(74) Vertreter: Maikowski, Michael, Dipl.-Ing. Dr.

(56) Entgegenhaltungen:
- WO-A-94/15223
- WO-A-96/34457
- FR-A- 2 477 807
- US-A- 5 541 562
- US-A- 5 646 587
- JOHN R. HINES ET AL.: "New Life for Hall Effect Sensors" MACHINE DESIGN., Bd. 57, Nr. 23, Oktober 1985 (1985-10), Seiten 83-87, XP002107079 CLEVELAND US

## Beschreibung

Die Erfindung bezieht sich auf einen kontaktlosen Näherungsschalter zur Erkennung von wenigstens einem vordefinierten Abstand zwischen einem ersten Teil und einem gegenüber diesem beweglich gelagerten zweiten Teil.

Bei bekannten berührungslosen Näherungsschaltern auf der Basis von magnetischen Sensoren ist im ersten Teil ein Dauermagnet und im zweiten Teil ein Reed-Relais, das bei Erreichen eines bestimmten Abstandes zum Dauermagenten aufgrund einer magnetischen Flussdichteänderung im Relais schaltet. Die Detektion einer Flussdichteänderung mittels eines Reed-Relais ist jedoch sehr störungsanfällig gegenüber externen Störmagnetfeldern in der Umgebung des magnetischen Systems und gegenüber Erschütterungen.

In A. Petersen, The magnetoresistive sensor, Electronic Components and Applications, Vol. 8, No. 4, p. 222 - 239, ist auf S. 235 ein Näherungsschalter bekannt, bei dem ein magnetoresistiver Sensor relativ zu einem Dauermagneten beweglich angeordnet ist. Bei diesem bekannen Näherungsschalter muß der Schaltpegel sehr hoch gewählt werden, um die Störempfindlichkeit gegenüber externen Störmagnetfeldern zu verringern.

Aus der US 5,646,587 ist ein Schalter mit einem Magneten und einem Hall-Sensor bekannt, bei dem der Magnet an dem Schalter befestigt ist. Durch Betätigung des Schalters wird die Lage des Magneten gegenüber seiner Ausgangslage verändert, wodurch im Hall-Sensor eine Änderung des wirksamen Magnetfeldes und damit eine Änderung des Sensorsignals erreicht wird.

Die Aufgabe der Erfindung besteht darin, einen verbesserten berührungslosen Näherungsschalter der eingangs genannten Art zu entwickeln, dessen Störempfindlichkeit insbesondere gegenüber externen Störmagnetfeldern und gegenüber Erschütterungen im Vergleich zu den bekannten Näherungsschaltern verbessert ist.

Diese Aufgabe wird durch einen kontaktlosen Näherungsschalter mit den Merkmalen des Anspruches 1 gelöst. Vorteilhafte Weiterbildungen des erfindungsgemässen kontaktlosen Näherungsschalters sind Gegenstand der Unteransprüche 2 bis 7. Bevorzugte Verwendungen des kontaktlosen Näherungsschalters sind Gegenstand der Ansprüche 8 bis 10.

Erfindungsgemäss ist vorgesehen, dass am ersten Teil ein magnetischer Winkelsensor befestigt ist, der ein von der Richtung eines auf ihn einwirkenden Magnetfeldes abhängiges Sensor-Ausgangssignal aufweist, und dass am zweiten Teil ein Ansteuermagnet mit einem Ansteuermagnetfeld befestigt ist, derart, dass bei Vorliegen des vordefinierten Abstandes zwischen dem ersten und dem zweiten Teil das Ansteuermagnetfeld im Winkelsensor eine Schaltzustands-Feldrichtung bewirkt, die von einer bei einem anderen als dem vordefinierten Abstand zwischen dem ersten und dem zweiten Teil vorliegenden Grundzustands-Feldrichtung im Winkelsensor verschieden ist, wobei dem magnetischen Winkelsensor ein Vorspannmagnetfeld zugeordnet ist, das die Grundzustands-Feldlinienrichtung definiert.

Ganz allgemein ist unter einem magnetischen Winkelsensor ein magnetischer Sensor mit mindestens einer von der Magnetfeldrichtung innerhalb des Sensors abhängigen elektrischen oder sonstigen Eigenschaft, die als Sensor-Ausgangssignal verwendbar ist, zu verstehen. Die Magnetfeldrichtung im Sensor ist beispielsweise mittels eines externen Magneten vorgegeben. Als Beispiel für einen magnetischen Winkelsensor sei der sogenannte GMR(Giant Magneto Resistor)-Sensor genannt, der einen von der Magnetfeldrichtung innerhalb des Sensors abhängigen elektrischen Widerstand aufweist und beispielsweise in der WO94/15223 näher erläutert ist.

Bei einer bevorzugten Ausführungsform des Näherungsschalters verlaufen die Ansteuerfeldlinienrichtung und die Grundzustand-Feldlinienrichtung antiparallel zueinander. Dadurch wird bei Erreichen des zu detektierenden Abstandes und somit beim Übergang von der die Grundzustand-Feldlinienrichtung in die Ansteuerfeldlinienrichtung eine maximale Sensorsignal-Änderung erzielt. Selbstverständlicherweise kann aber auch jeder beliebige andere Winkel ungleich 0° zwischen den beiden Feldrichtungen gewählt werden. Je kleiner der Winkel, umso geringer ist aber die Sensorsignal-Änderung und umso höher muss Auflösung der verwendeten Sensorsignal-Auswerteschaltung sein.

Eine besonders bevorzugte Ausführungsform des kontaktlosen Näherungsschalters weist einen Vorspannmagneten auf, in dessen Vorspannmagnetfeld der magnetische Winkelsensor angeordnet ist. Das Vorspannmagnetfeld definiert die Grundzustands-Feldlinienrichtung des magnetischen Winkelsensors. Bei Vorliegen des zu erkennenden Abstandes zwischen dem ersten und dem zweiten Teil sind das Ansteuermagnetfeld und das Vorspannmagnetfeld im Bereich des Winkelsensor überlagert. Die beiden Magnetfelder sind so dimensioniert, dass in dieser Position im Winkelsensor das Ansteuermagnetfeld gegenüber dem Vorspannmagnetfeld überwiegt und damit die effektiv Feldlinienrichtung im Winkelsensor der des Ansteuermagneten entspricht.

Die Feldlinienrichtung des Ansteuermagnetfeldes und die Grundzustands-Feldlinienrichtung bewirken im magnetischen Winkelsensor unterschiedliche Sensor-Ausgangssignale. Der magnetische Winkelsensor geht folglich bei hinreichender Annäherung des Ansteuermagneten vom Grundzustand in einen Schaltzustand über. Besonders bevorzugt wird bei dem erfindungsgemässen kontaktlosen Näherungsschalter als magnetischer Winkelsensor der oben bereits genannte GMR(Giant Magneto Resistor)-Sensor eingesetzt. Der Ansteuermagnet und der Vorspannmagnet sind bevorzugt Dauermagneten. Es können dafür aber auch Elektromagneten eingesetzt werden. Dies bringt den Vorteil mit sich, dass der vordefinierte Abstand, bei dem der magnetische Winkelsensor vom Grundzustand in den Schaltzustand übergehen soll, durch Variation der magnetischen Feldstärke des Ansteuermagneten oder des Vorspannmagneten verändert werden kann.

Der erfindungsgemässe kontaktlose Näherungsschalter wird im folgenden anhand von fünf Ausführungsbeispielen in Verbindung mit den Figuren 1 bis 9 näher erläutert. Es zeigen:
Figur 1 eine schematische Darstellung des ersten Ausführungsbeispieles,
Figur 2 eine schematische Darstellung des zweiten Ausführungsbeispieles,
Figur 3 eine schematische Darstellung des dritten Ausführungsbeispieles,
Figur 4 eine schematische Darstellung des vierten Ausführungsbeispieles,
Figur 5 eine schematische Darstellung des fünften Ausführungsbeispieles,
Figur 6 eine schematische Darstellung eines beispielhaften Verlaufs des Sensor-Ausgangssignals,
Figur 7 eine schematische Darstellung eines Mobiltelefons mit einem Näherungsschalter gemäß der Erfindung,
Figur 8 eine schematische Darstellung eines Automobils mit einem Näherungsschalter gemäß der Erfindung und
Figur 9 eine schematische Darstellung eines Kühl- oder Gefrierschrankes mit einem Näherungsschalter gemäß der Erfindung.

Gleiche oder gleichwirkende Bestandteile der verschiedenen Ausführungsbeispiele sind in den Figuren jeweils mit denselben Bezugszeichen versehen.

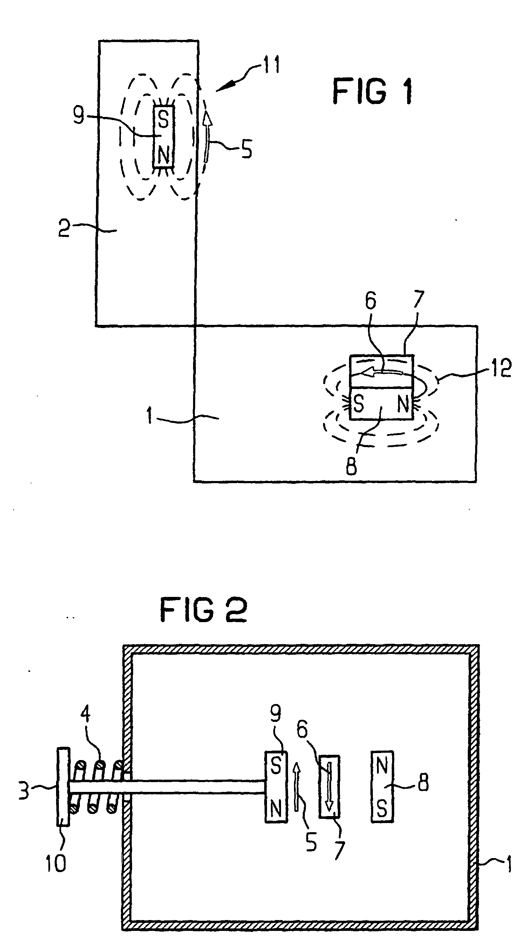

Bei dem Ausführungsbeispiel von Figur 1 ist in einem Gehäuse 1, z. B. ein Mobiltelefon-Gehäuse, ein magnetischer Winkelsensor 7 in Form eines Magnetoresistors (z.B. ein GMR) und, diesem benachbart, ein Vorspannmagnet 8 angeordnet. An dem Gehäuse 1 ist ein Klappdeckel 2, z. B. ein ausklappbares Mikrofonteil des o.g. Mobiltelefons, befestigt, der drehbar zum Gehäuse 1 gelagert ist. In dem Klappdeckel 2 befindet sich ein Ansteuermagnet 9 mit einem Ansteuermagnetfeld 11, dessen Ansteuerfeldrichtung 5 (Schaltzustandsfeldrichtung) anti-parallel zu einer Grundzustandsfeldrichtung 6 des magnetischen Winkelsensors 7 verläuft. Die Ansteuerfeldrichtung 5 und die Grundzustandsfeldrichtung 6 können aber auch jeden beliebigen anderen Winkel ungleich 0° oder 360° einschließen.

Die Grundzustandsfeldrichtung 6 des magnetischen Winkelsensors 7 ist durch das magnetische Feld des Vorspannmagneten 8 definiert.

Bei Annäherung des Ansteuermagneten 9 an den magnetischen Winkelsensor 7 gerät dieser immer stärker in den Einflussbereich des Magnetfeldes des Ansteuermagneten 9 und verlässt infolge einer Überlagerung des Vorspannmagnetfeldes mit dem Ansteuermagnetfeld seinen Grundzustand. Bei Erreichen des vorbestimmten Abstandes zwischen dem Gehäuse 1 und dem Klappdeckel 2, z. B. bei geschlosssenem Klappdeckel 2, ist die Feldlinienrichtung im magnetischen Winkelsensor 7 gegenüber der Grundzustandsfeldlinienrichtung 6, im Beispiel um 180°, gedreht und der Winkelsensor 7 weist folglich einen gegenüber dem Grundzustand veränderten elektrischen Widerstand (Ausgangssignal) auf, der dem Schaltzustand entspricht. Die Änderung des Ausgangssignals wird von einer geeigneten Auswerteschaltung ausgewertet.

Der Ansteuermagnet und der Vorspannmagnet sind beispielsweise Dauermagneten oder Elektromagneten.

Bei dem Ausführungsbeispiel von Figur 2 handelt es sich um einen Tastschalter, bei dem an einem Tastkopf 3, der in ein Gehäuse 1 führt, innerhalb des Gehäuses 1 ein Ansteuermagnet 9 befestigt ist. Eine Grundstellung des Tastkopfes 3 ist mittels einer ausserhalb des Gehäuses 1 zwischen einer Tastplatte 10 des Tastkopfes 3 und einer Gehäuseaussenwand angeordneten Feder 4 eingestellt. Innerhalb des Gehäuses 1 befindet sich als magnetischer Winkelsensor 7 ein Magnetoresistor, der mittels eines in dessen Nähe angeordneten Vorspannmagneten 8 in einen definierten Grundzustand gebracht ist.

Die Magnetfeldrichtungen 5,7 des Ansteuermagneten 9 und des Vorspannmagneten 8 verlaufen antiparallel zueinander.

Bei Drücken des Tastkopfes 3 in Richtung des Gehäuses 1 verringert sich der Abstand zwischen dem Ansteuermagneten 9 und dem Winkelsensor 7, so dass dieser immer stärker in den Einflussbereich des Magnetfeldes des Ansteuermagneten 9 gerät und infolge einer Überlagerung des Vorspannmagnetfeldes mit dem Ansteuermagnetfeld seinen Grundzustand verlässt. Dadurch kommt es zu einer Änderung des elektrischen Widerstandes (Ausgangssignal) des magnetischen Winkelsensors 7.

Bei Erreichen einer vorbestimmten Tastkopfstellung, d. h. eines bestimmten Abstandes zwischen dem Gehäuse 1 und der Tastplatte 10, ist die Feldlinienrichtung im magnetischen Winkelsensor 7 gegenüber der Grundzustandsfeldlinienrichtung 6 um einen diesem Abstand entsprechenden Wert gedreht, im Beispiel um 180°. Der Winkelsensor 7 weist dann einen gegenüber dem Grundzustand veränderten elektrischen Widerstand (Ausgangssignal) auf, der dem Schaltzustand entspricht. Die Änderung des Ausgangssignals wird von einer geeigneten Auswerteschaltung ausgewertet.

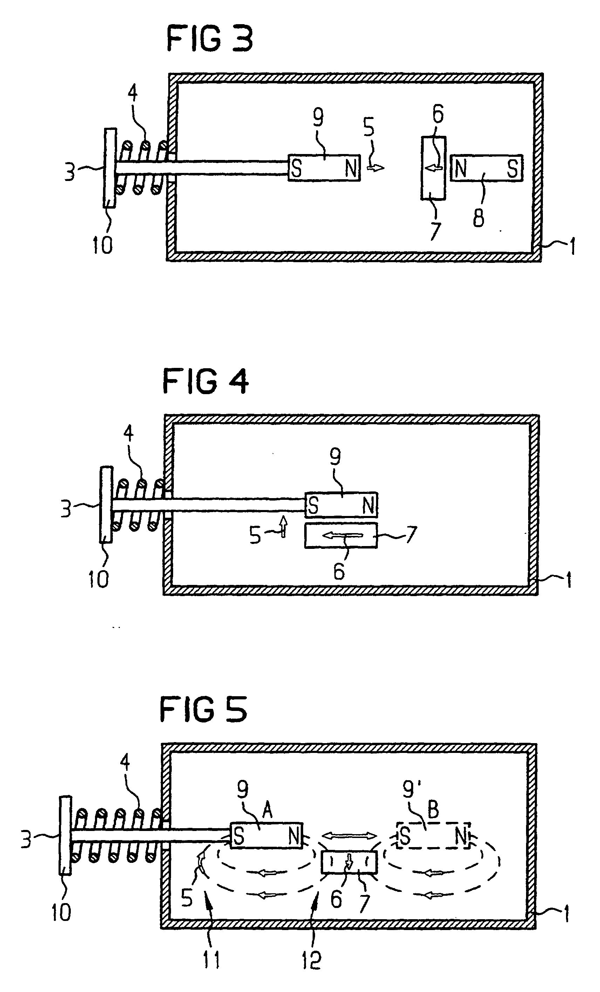

Das Ausführungsbeispiel von Figur 3 entspricht im Wesentlichen dem zuletzt beschriebenen, lediglich der Ansteuermagnet und der Vorspannmagnet sind gegenüber diesem um 90° Grad verdreht angeordnet. Die Funktionsweise dieses Ausführungsbeispiels ist analog.

Bei dem Ausführungsbeispiel von Figur 4 handelt es sich ebenfalls um einen Tastschalter entsprechend dem zweitgenannten Ausführungsbeispiel. Im Unterschied zu diesem ist aber hier kein Vorspannmagnet vorgesehen. Hier ist der Grundzustand des magnetischen Winkelsensors 7, dieser liegt bei nicht gedrücktem Testkopf vor, durch den Ansteuermagneten 9 definiert, der parallelverschoben zu einer Bewegungsachse, auf der sich der Ansteuermagnet 9 beim Drücken des Tastkopfes 3 bewegt, angeordnet ist. In diesem Beispiel befindet ist der Winkelsensor 7 bei nicht gedrücktem Tastkopf 3, also im Grundzustand genau unterhalb des Ansteuermagneten 9, dessen Magnetfeld in dessen Innerem horizontal verläuft. Die Grundzustandsfeldrichtung 6 im Winkelsensor 7 verläuft damit ebenfalls waagrecht.

Beim Drücken des Tastkopfes 3 wird der Ansteuermagnet 9 über den Winkelsensor 7 hinausgeschoben, so dass der Winkelsensor 7 in den Bereich der vertikal stehenden Ansteuerfeldrichtung 5 parallel zur Stirnfläche des Ansteuermagneten 9 gelangt, die gegenüber der Grundzustandsfeldrichtung 6 um 90° gedreht ist. Infolgedessen liegt auch hier bei gedrücktem Tastkopf 3 ein gegenüber dem Grundzustand veränderter elektrischer Widerstand des Winkelsensors 7 vor.

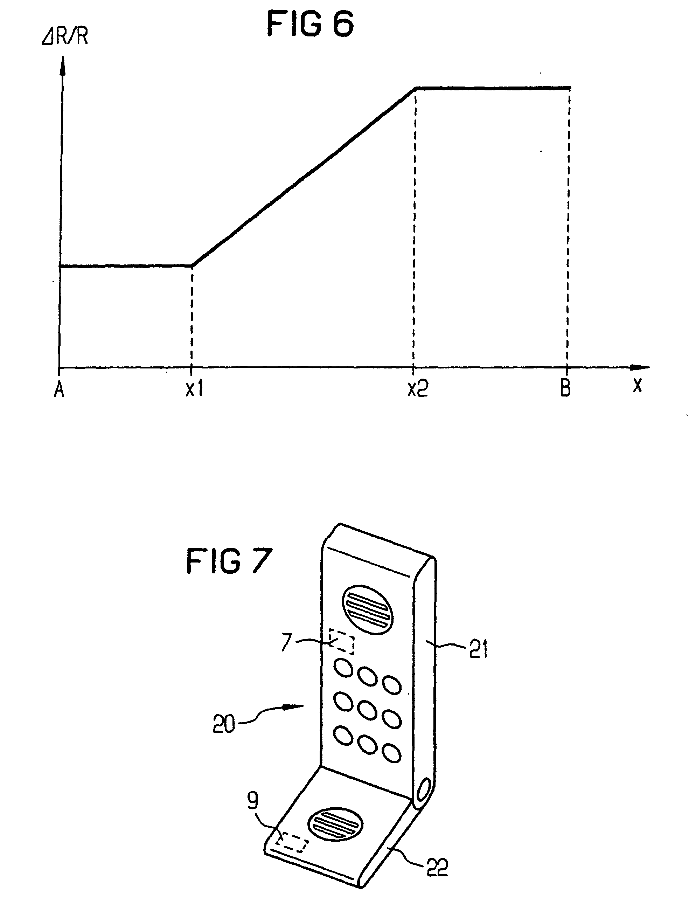

Das in Figur 5 dargestellte Ausführungsbeispiel entspricht im Wesentlichen dem zuletzt erläuterten Tastschalter. Im Unterschied dazu befindet sich jedoch hier der Ansteuermagnet 9 in der Ruheposition des Tastkopfes 3 (Grundzustand) von der Tastplatte 10 aus gesehen vor dem Winkelsensor 7 und bei gedrücktem Tastkopf 3 von der Tastplatte 10 aus gesehen nach dem Winkelsensor 7 (in Figur 5 durch den gestrichelt eingezeichneten Ansteuermagneten 9' angedeutet). Der Ansteuermagnet 7 wird folglich während des Drückens des Tastkopfes 3 am Winkelsensor 7 vorbeigeschoben, so dass sich die Feldrichtung im Winkelsensor 7 insgesamt um 180° dreht und eine maximale Widerstandsänderung des Winkelsensors 7 hervorgerufen wird.

Eine mögliche Signaländerung während des Vorbeiführens des Ansteuermagneten 9 am Winkelsensor 7 (Bewegung von Position A zur Position B) ist in dem Diagramm von Figur 6 schematisch dargestellt. Auf der horizontalen Achse ist der zurückgelegte Weg x und auf der vertikalen Achse ist das Verhältnis ΔR/R aufgetragen, wobei R der elektrische Widerstand des Winkelsensors 7 ist. Während der Bewegung des Ansteuermagneten 9 von A nach B ist ΔR/R zunächst bis zum Beginn der Änderung der Magnetfeldrichtung im Winkelsensor am Punkt x1 konstant, wird dann während der Drehung der Magnetfeldrichtung im Winkelsensor 7 kontinuierlich größer und erreicht am Punkt x2, an dem die Magnetfeldrichtung im Winkelsensor 7 um 180° gedreht ist, einen Maximalwert. Schaltpunkte des Tastschalters können mittels Anpassung der Signalauswerteschaltung für den Winkelsensor 7 an beliebigen voneinander verschiedenen Punkten im ansteigenden Bereich der Kurve zwischen x1 und x2 gewählt werden. Dadurch kann beispielsweise die Empfinglichkeit des Tastschalters auf einfache Weise variiert werden. Die Ausführungsbeispiele der Figuren 1 bis 4 weisen ähnliche Signalverläufe auf.

Mit dem erfindungsgemäßen Näherungsschalter kann vorteilhafterweise nicht nur ein einziger sondern können verschiedene Abstandswerte zwischen dem ersten und dem zweiten Teil detektiert werden. Die Abstandswerte müssen lediglich jeweils eindeutig einem ΔR/R-Wert zugeordnet werden können.

Bei den in Verbindung mit den Figuren 4 und 5 erläuterten Ausführungsbeispielen ist es beispielsweise bei Verwendung eines GMR-Sensors als Winkelsensor 7 nicht notwendig, dass sich dieser im Grundzustand oder im Schaltzustand permanent im Einflußbereich des Ansteuermagnetfeldes befindet, da ein GMR-Sensor so lange seine Magnetisierungsrichtung in der Meßschicht behält, bis die nächste von einem externen Magnetfeld hervorgerufene Ummagnetisierung erfolgt.

Bevorzugt wird der kontaktlose Näherungsschalters in einem Mobiltelefon 20 (Figur 7) mit einem von einem Lautsprecherteil 21 wegklappbaren Klappdeckel (zum Abdecken der Tastatur) oder Mikrofonteil 22 zum gleichzeitigen Ein- oder Ausschalten des Mobiltelefons 20 beim Auf- bzw. Zuklappen des Klappdekkels bzw. Mikrofonteils 22 eingesetzt. Der Klappdeckel bzw. das Mikrofonteil 22 oder das Lautsprecherteil 21 weist hierbei den Ansteuermagneten 9 und das Lautsprecherteil 21 bzw. das Mikrofonteil 22 den magnetischen Winkelsensor 7 auf.

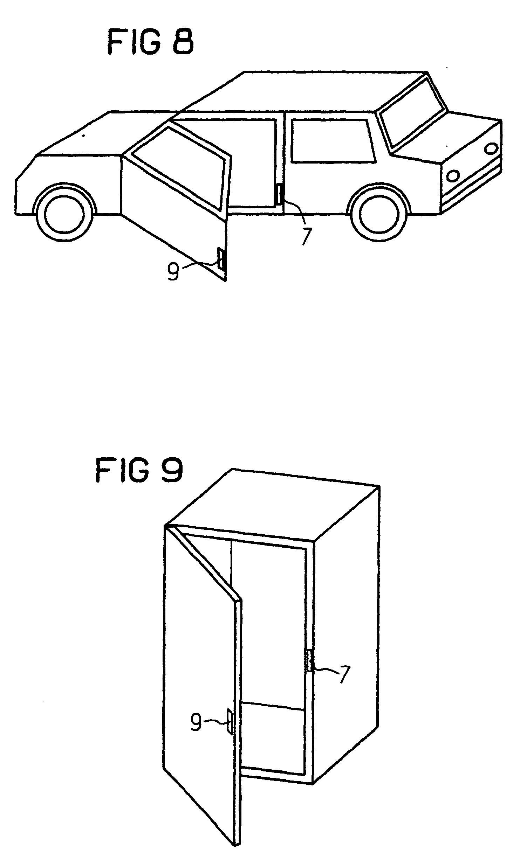

Ebenso kann der Näherungsschalter vorteilhafterweise als Tür-Schalter für die Innenbeleuchtung in Kraftfahrzeugen (Figur 8) oder Kühl- oder Gefrierschränken (Figur 9) verwendet werden.

Die Erfindung ist selbstverständlich nicht auf die oben beschriebenen Ausführungsbeispiele eingeschränkt. Sie ist vielmehr generell überall dort anwendbar, wo die Annäherung eines ersten Teiles an ein zweites Teil erkannt werden soll.

## Patentansprüche

1. Kontaktloser Näherungsschalter zur Erkennung von mindestens einem vordefinierten Abstand zwischen einem ersten Teil (1) und einem gegenüber diesem beweglichen zweiten Teil (2,10),
**dadurch gekennzeichnet, dass**
der erste Teil (1) und der zweite Teil (2) klappbar miteinander verbunden sind und am ersten Teil (1) ein magnetischer Winkelsensor (7) befestigt ist, der ein von der Richtung eines auf ihn einwirkenden Magnetfeldes abhängiges Sensor-Ausgangssignal aufweist, und dass am zweiten Teil (2) ein Ansteuermagnet (9) mit einem Ansteuermagnetfeld (11) befestigt ist, derart, dass bei Vorliegen des vordefinierten Abstandes zwischen dem ersten (1) und dem zweiten Teil (2,10) das Ansteuermagnetfeld (11) im Winkelsensor (7) eine Schaltzustands-Feldrichtung (5) bewirkt, die von einer bei einem anderen als dem vordefinierten Abstand zwischen dem ersten (1) und dem zweiten Teil (2,10) vorliegenden Grundzustands-Feldrichtung (6) im Winkelsensor (7) verschieden ist, wobei dem magnetischen Winkelsensor (7) ein Vorspannmagnetfeld (12) zugeordnet ist, das die Grundzustands-Feldlinienrichtung (6) definiert.

2. Kontaktloser Näherungsschalter nach Anspruch 1, **dadurch gekennzeichnet, daß** sich der Winkelsensor (7) bei Nichtvorliegen des vordefinierten Abstandes zwischen dem ersten (1) und dem zweiten Teil (2,10) in einem Bereich des Magnetfeldes des Ansteuermagneten (9) befindet, in dem sich dessen Magnetfeldrichtung von der Schaltzustands-Feldrichtung (5) unterscheidet, so dass das Vorspannmagnetfeld (12) von dem Ansteuermagneten (9) erzeugt ist.

3. Kontaktloser Näherungsschalter nach Anspruch 1, **dadurch gekennzeichnet, dass** die Grundzustands-Feldlinienrichtung (6) von einem Vorspannmagnet (8) erzeugt ist.

4. Kontaktloser Näherungsschalter nach einem der Ansprüch 1 bis 3, **dadurch gekennzeichnet, dass** die Grundzustands-Feldrichtung (6) antiparallel zur Schaltzustands-Feldrichtung (5) verläuft.

5. Kontaktloser Näherungsschalter nach einem der Ansprüche 1 bis 4, **dadurch gekennzeichnet, dass** der magnetische Winkelsensor (7) ein GMR-Sensor ist.

6. Kontaktloser Näherungsschalter nach einem der Ansprüche 1 bis 5, **dadurch gekennzeichnet, dass** der Ansteuermagnet (9) und/oder der Vorspannmagnet (8) ein Dauermagnet ist.

7. Kontaktloser Näherungsschalter nach einem der Ansprüche 1 bis 6, **dadurch gekennzeichnet, dass** der Ansteuermagnet (9) und/oder der Vorspannmagnet (8) ein Elektromagnet ist.

8. Verwendung des kontaktlosen Näherungsschalters gemäß einem der Ansprüche 1 bis 7 in einem Mobiltelefon (20) mit einem von einem Lautsprecherteil (21) wegklappbaren Klappdeckel oder Mikrofonteil (22) zum gleichzeitigen Ein- oder Ausschalten des Mobiltelefons (20) beim Auf- bzw. Zuklappen des Klappdeckels bzw. des Mikrofonteils (22), bei dem der Klappdeckel bzw. das Mikrofonteil (22) den Ansteuermagneten (9) und das Lautsprecherteil (21) den magnetischen Winkelsensor (7) oder das Lautsprecherteil (21) den Ansteuermagneten (9) und der Klappdeckel bzw. das Mikrofonteil (22) den magnetischen Winkelsensor (7) aufweist.

9. Verwendung des kontaktlosen Näherungsschalters gemäß einem der Ansprüche 1 bis 7 als Türschalter für die Innenbeleuchtung eines Automobils, bei dem mindesten eine der Autotüren den Ansteuermagneten (9) oder den magnetischen Winkelsensor (7) und die Türaufnahme der Karosserie den magnetischen Winkelsensor (7) bzw. den Ansteuermagneten (9) aufweist.

10. Verwendung des kontaktlosen Näherungsschalters gemäß einem der Ansprüche 1 bis 7 als Türschalter für die Innenbeleuchtung eines Kühl- und/oder Gefrierschrankes, bei dem eine Kühl- und/oder Gefrierschranktür den Ansteuermagneten (9) oder den magnetischen Winkelsensor (7) und die Türaufnahme des Kühl- und/oder Gefrierschrankes den magnetischen Winkelsensor (7) bzw. den Ansteuermagneten (9) aufweist.

## Claims

1. Contactless proximity switch for detecting at least one predefined spacing between a first part (1) and a second part (2, 10), which can be moved with respect thereto, **characterized in that** the first part (1) and the second part (2) are connected to one another in a folding manner and fastened to the first part (1) is a magnetic angle sensor (7) which exhibits a sensor output signal dependent on the direction of a magnetic field acting on it, and **in that** a drive magnet (9) with a driving magnetic field (11) is fastened to the second part (2) in such a way that, given the presence of the predefined spacing between the first (1) and the second part (2, 10), the driving magnetic field effects in the angle sensor (7) a switching state field direction (5) which differs from an original state field direction (6) in the angle sensor (7) which is present in the event of a spacing other than the predefined one between the first (1) and the second part (2, 10), the magnetic angle sensor (7) being assigned a biasing magnetic field (12) which defines the direction (6) of the original state field lines.

2. Contactless proximity switch according to Claim 1, **characterized in that** in the event of the absence of the predefined spacing between the first (1) and the second part (2, 10) the angle sensor (7) is located in a region of the magnetic field of the driving magnet (9) in which its magnetic field direction differs from the switching state field direction (5) such that the biasing magnetic field (12) is generated by the driving magnet (9).

3. Contactless proximity switch according to Claim 1, **characterized in that** the direction (6) of the original state field lines is generated by a biasing magnet (8).

4. Contactless proximity switch according to one of Claims 1 to 3, **characterized in that** the original state field direction (6) runs in an anti-parallel fashion relative to the switching state field direction (5).

5. Contactless proximity switch according to one of Claims 1 to 4, **characterized in that** the magnetic angle sensor (7) is a GMR sensor.

6. Contactless proximity switch according to one of Claims 1 to 5, **characterized in that** the drive magnet (9) and/or the biasing magnet (8) are/is a permanent magnet.

7. Contactless proximity switch according to one of Claims 1 to 6, **characterized in that** the drive magnet (9) and/or the biasing magnet (8) are/is an electromagnet.

8. Use of the contactless proximity switch according to one of Claims 1 to 7 in a mobile telephone (20) having a folding cover or microphone part (22), which can be folded away from a loudspeaker part (21), for simultaneously switching the mobile telephone (20) on or off when folding the folding cover or the microphone part (22) open or shut, in which the folding cover or the microphone part (22) has the drive magnet (9) and the loudspeaker part (21) has the magnetic angle sensor (7), or the loudspeaker part (21) has the drive magnet (9) and the folding cover or the microphone part (22) has the magnetic angle sensor (7).

9. Use of the contactless proximity switch according to one of Claims 1 to 7 as door switch for the interior illumination of an automobile, in which at least one of the automobile doors has the drive magnet (9) or the magnetic angle sensor (7), and the door receptacle of the body has the magnetic angle sensor (7) or the drive magnet (9).

10. Use of the contactless proximity switch according to one of Claims 1 to 7 as door switch for the interior illumination of a refrigerator and/or freezer, in which the door of a refrigerator and/or freezer has the drive magnet (9) or the magnetic angle sensor (7), and the door receptacle of the refrigerator and/or freezer has the magnetic angle sensor (7) or the drive magnet (9).

## Revendications

1. Détecteur de proximité sans contact, pour détecter au moins une distance prédéfinie entre une première pièce (1) et une deuxième pièce (2, 10) mobile par rapport à la première pièce,
**caractérisé en ce que** la première pièce (1) et la deuxième pièce (2) sont reliées entre elles de façon rabattable et un capteur d'angle magnétique, dont le signal de sortie est fonction de la direction d'un champ magnétique agissant sur le capteur d'angle, est fixé à la première pièce (1), et **en ce qu'**un aimant de commande (9) générant un champ magnétique de commande (11) est fixé à la deuxième pièce (2) de telle sorte que, lorsqu'il y a une distance prédéfinie entre la première pièce (1) et la deuxième pièce (2, 10), le champ magnétique de commande (11) génère dans le capteur d'angle (7) une direction de champ à l'état de commutation, qui est différente d'une direction de champ à l'état de base (6) lorsque la distance entre la première pièce (1 ) et la deuxième pièce (2, 10) est différente de celle prédéfinie dans le capteur d'angle ; un champ magnétique de polarisation (12), qui définit la direction de lignes de champ (6) à l'état de base, étant associé au capteur d'angle magnétique (7).

2. Détecteur de proximité sans contact selon la revendication 1, **caractérisé en ce que**, lorsqu'il n'y a pas la distance prédéfinie entre la première pièce (1) et la deuxième pièce (2, 10), le capteur d'angle (7) se trouve dans une région du champ magnétique de l'aimant de commande (9), dans laquelle la direction du champ magnétique de l'aimant de commande se distingue de la direction du champ (5) à l'état de commutation de sorte que le champ magnétique de polarisation (12) est généré par l'aimant de commande (9).

3. Détecteur de proximité sans contact selon la revendication 1, **caractérisé en ce que** la direction des lignes de champ (6) à l'état de base est générée par un aimant de polarisation (8).

4. Détecteur de proximité sans contact selon l'une des revendications 1 à 3, **caractérisé en ce que** la direction de champ (6) à l'état de base s'étend de façon antiparallèle à la direction de champ (5) à l'état de commutation.

5. Détecteur de proximité sans contact selon l'une des revendications 1 à 4, **caractérisé en ce que** le capteur d'angle magnétique (7) est un capteur GMR.

6. Détecteur de proximité sans contact selon l'une des revendications 1 à 5, **caractérisé en ce que** l'aimant de commande (9) et/ou l'aimant de polarisation (6) est un aimant permanent.

7. Détecteur de proximité sans contact selon l'une des revendications 1 à 6, **caractérisé en ce que** l'aimant de commande (9) et/ou l'aimant de polarisation (8) est un électroaimant.

8. Utilisation du détecteur de proximité sans contact selon l'une des revendications 1 à 7 dans un téléphone mobile (20) comportant un capot rabattable ou pièce à microphone (22), pouvant être écarté d'une pièce à haut-parleur (21) pour mettre en route ou arrêter simultanément le téléphone mobile (20) lorsque le capot rabattable ou pièce à microphone (22) est ouvert ou fermé, le capot rabattable ou pièce à microphone (22) comportant l'aimant de commande (9) et la pièce à haut-parleur (21) comportant le capteur d'angle magnétique (7) ou la pièce à haut-parleur (21) comportant l'aimant de commande (9) et le capot rabattable ou pièce à microphone (22) comportant le capteur d'angle magnétique (7).

9. Utilisation du détecteur de proximité sans contact selon l'une des revendications 1 à 7 comme commutateur de portière pour l'éclairage intérieur d'une automobile, dans lequel au moins l'une des portières de l'automobile comporte l'aimant de commande (9) ou le capteur d'angle magnétique (7) et le montant de portière de la carrosserie comporte le capteur d'angle magnétique (7) ou l'aimant de commande (9).

10. Utilisation du détecteur de proximité sans contact selon l'une des revendications 1 à 7 comme commutateur de porte pour l'éclairage intérieur d'un réfrigérateur et/ou d'un congélateur, dans lequel une porte de réfrigérateur et/ou de congélateur comporte l'aimant de commande (9) ou le capteur d'angle magnétique (7) et le cadre de porte du réfrigérateur et/ou du congélateur comporte le capteur d'angle magnétique (7) ou l'aimant de commande (9).
